# EUROPEAN PATENT APPLICATION

(11) **EP 2 000 735 A1**
(43) Date of publication of application: **10.12.2008**
(21) Application number: 08251953.9
(22) Date of filing: 05.06.2008
(51) Int. Cl.: F17C 13/00, F17C 3/08

(54) **Cooling system for cryogenic storage container and operating method therefor**

(30) Priority: 08.06.2007 JP 2007153015
(71) Applicant: Hitachi, Ltd., Chiyoda-ku Tokyo (JP)
(72) Inventor: Tanaka, Hiroyuki, Chiyoda-ku Tokyo 100-8220 (JP); Saho, Norihide, Chiyoda-ku Tokyo 100-8220 (JP); Isogami, Hisashi, Chiyoda-ku Tokyo 100-8220 (JP)
(74) Representative: Calderbank, Thomas Roger

(57) **Abstract**

In a cooling system for a cryogenic storage container in which a heat shield provided between a storage container storing an object to be cooled as soaked in a coolant is cooled by a coolant cooled by a cryogenic freezer, a vibration occurring in the cryogenic freezer and the amount of evaporation of a coolant from a coolant storage container can be suppressed. A cryogenic storage container provided with a storage container, a vacuum container containing the storage container, and a heat shield is coupled to a cooling source equipped with a cryogenic freezer via transport piping so that the vibration of the cryogenic freezer cannot be directly delivered to the cryogenic storage container. The vibration can be further reduced by providing a bellows unit for transport piping. In a circulating cooling system using a helium gas cooled at a cryogenic temperature, a low temperature side shield in two provided heat shields is cooled using a coolant cooled at the lowest temperature, then an only one provided heat shield is cooled, and finally a high temperature side shield in the two provided heat shields is cooled, thereby suppressing the amount of evaporation of a coolant.

## Description

The present invention relates to a system for a cryogenic storage container and its operating method, and more specifically to a cooling system for a cryogenic storage container by using a coolant such as a liquid helium for cooling at a cryogenic temperature and its operating method.

Recently, there is an increasing demand for a device requiring a high magnetic field such as an MRI and an NMR. Such a device uses a superconductive magnet for generating a high magnetic field. In addition, a device using superconductivity is applied to measure a weak magnetic field. These objects to be cooled are cooled as soaked in a low temperature coolant, and normally liquid helium having a boiling point of 4.2 K (-269°C) is used as a coolant.

Liquid helium is low in evaporation latent heat, and the evaporation latent heat of the liquid helium under an atmospheric pressure is 20.7 [kJ/kg] which is not more than 1/100 of the evaporation latent heat (2257 [kJ/kg]) of water under the atmospheric pressure, and a large amount of liquid helium evaporates by slight heat invasion. Therefore, in a cooling system using liquid helium, it is necessary to periodically supply liquid helium.

A well-known method to suppress the heat invasion into the liquid helium stored in a cryogenic container is to provide a heat shield in a vacuum tank between a container storing liquid helium and a vacuum container, cool the heat shield down to the intermediate temperature between the room temperature of the vacuum container and the temperature of the liquid helium, and prevent the radiant heat from the vacuum container at the room temperature from directly being delivered to the liquid helium container (for example, refer to JP-A-2002-232030 and JP-A-2002-232029).

Normally, two heat shields are provided, and the high-temperature side heat shield provided on the vacuum container side is about 77 K to 200 K, and the heat shield provided on the liquid helium storage container side is about 4.2 K to 77 K.

The sensible heat of a helium gas evaporated from liquid helium is commonly used as a cooling source of a heat shield. In this case, when the amount of evaporation of the liquid helium becomes low, the flow rate of the helium gas decreases, thereby degrading the performance of cooling the heat shield, and raising the heat shield cooling temperature.

To provide a heat shield, it is necessary to reserve a space to suppress contact between the heat shield and the container storing the liquid helium, and a space to suppress contact between the heat shield and the vacuum container. When there are two heat shields, it is further necessary to reserve a space to prevent contact between the inner (low temperature side) heat shield and the outer (high temperature side) heat shield, and the distance between an object to be cooled and provided in a container storing liquid helium and the surface of a vacuum container is long.

In the living body magnetic measurement, since the distance between a superconductive device as an object to be cooled and the surface of a vacuum container largely affects the sensitivity, there is a request to shorten the distance between the object to be cooled and the surface of a vacuum container as much as possible. In addition, with the superconductive magnet generating a high magnetic field, there is a request to utilize a higher magnetic field by shortening the distance between a superconductive magnet as an object to be cooled and the surface of a vacuum container.

To fulfill the requests, it is desired to obtain the structure of a cryogenic container with the shorter distance between an object to be cooled and the surface of a vacuum container. In JP-A-2002-232030, there is one heat shield to shorten the distance between a storage container and a vacuum container.

By cooling the heat shield at a low temperature, the amount of evaporation of liquid helium can be reduced even with one heat shield. Therefore, a method of cooling a heat shield using a cryogenic freezer is well known.

When a freezer is not used, the cooling source of the heat shield is the sensible heat of the helium gas evaporated from the liquid helium. Therefore, when there is a small amount of evaporation, the temperature at which the helium gas cools the heat shield rises, and the amount of radiant heat from the heat shield increases. Without a cryogenic freezer, the heat shield temperature and the amount of evaporation of the liquid helium depend on the balance between the temperature of the heat shield and the heat shield cooling function of the evaporated helium gas.

However, by using the cryogenic freezer, the heat shield can be cooled down to a lower temperature with a smaller amount of evaporation of the liquid helium, thereby reducing the amount of evaporation of the liquid helium.

The insulating function of a cryogenic coolant storage container is improved by utilizing a cryogenic freezer. However, a cryogenic freezer necessarily generates a vibration although at different levels depending on the difference in the structure of a freezer and a cooling system. Therefore, it is difficult to apply it to a living body magnetic measurement and a magnet for an NMR in which a slight vibration can affect the sensitivity.

To enhance the sensitivity of a superconductive device as an object to be cooled, or enhance the intensity of the magnetic field on the surface of a vacuum container in a superconductive magnet, it is necessary to shorten the distance from an object to be cooled to the surface of a vacuum container. To realize this, the number of heat shields provided for the vacuum tank between the storage container and the vacuum container has been decreased to suppress the space provided to prevent the contact between the heat shields and shorten the distance between the storage container and the vacuum container. However, there has been the problem with a multichannel superconductive device and a higher magnetic field of a superconductive magnet that the surface area of the portion for which only one heat shield can be provided becomes large, and the radiant heat from the heat shield to the storage container increases.

The object of the present invention is to provide a cooling system for a cryogenic storage container which may address the problem of the vibration occurring when a heat shield is cooled using a cryogenic freezer, and an operating method for suppressing the amount of evaporation of a coolant from a cryogenic storage container.

The present invention is a cooling system for a cryogenic storage container including: a storage container storing an object to be cooled as soaked in a coolant; a vacuum container provided around the storage container and forming a vacuum tank between the vacuum container and the storage container; a heat shield provided for the vacuum tank; a cryogenic storage container having coolant piping fixed to the heat shield; a cooling source provided with a cryogenic freezer for cooling a coolant passing through the coolant piping; and coolant transport piping coupling the cooling source to the cryogenic storage container, wherein the coolant cooled by the cryogenic freezer is delivered to the cryogenic storage container through the transport piping.

The present invention is also a cooling system for a cryogenic storage container including:
a cryogenic storage container having a storage container storing a coolant and an object to be cooled, a vacuum container provided around the storage container and forming a vacuum tank between the vacuum container and the storage container, and a heat shield provided in the vacuum tank, wherein the heat shield has a portion having two heat shields between the storage container and the vacuum container, and a portion having one heat shield between the storage container and the vacuum container, coolant piping is fixed to each of the two provided heat shields and the one provided heat shield, a different coolant other than the coolant stored in the storage container passes through the coolant piping, and the coolant passing through the coolant piping cools the two provided heat shield and the one provided heat shield;
a cooling source having a second vacuum container which is vacuum inside, a cryogenic freezer provided in the second vacuum container, at least one heat exchange unit provided in the second vacuum container and attached to a coolness generation unit of the cryogenic freezer, at least one counterflow heat exchanger provided in the second vacuum container, and second coolant piping passing a coolant inside, wherein the heat exchange unit is coupled to the counterflow heat exchanger via the second coolant piping; and
transport piping having third coolant piping passing a coolant inside, and a third vacuum container forming a vacuum tank between the third vacuum container and the third coolant piping, wherein
the coolant piping fixed to the heat shield provided in the cryogenic storage container is coupled to the second coolant piping provided in the cooling source via the third coolant piping, and the vacuum container in the cryogenic storage container is coupled to the second vacuum container in the cooling source via the third vacuum container.

The present invention is also an operating method for a cooling system for a cryogenic storage container including:
a cryogenic storage container having a storage container storing a coolant and an object to be cooled, a vacuum container provided around the storage container and forming a vacuum tank between the vacuum container and the storage container, and a heat shield provided in the vacuum tank, wherein the heat shield has a portion having two heat shields between the storage container and the vacuum container, and a portion having one heat shield between the storage container and the vacuum container, coolant piping is fixed to each of the two provided heat shields and the one provided heat shield, a different coolant other than the coolant stored in the storage container passes through the coolant piping, and the coolant passing through the coolant piping cools the two provided heat shield and the one provided heat shield;
a cooling source having a second vacuum container which is vacuum inside, a cryogenic freezer provided in the second vacuum container, at least one heat exchange unit provided in the second vacuum container and attached to a coolness generation unit of the cryogenic freezer, at least one counterflow heat exchanger provided in the second vacuum container, and second coolant piping passing a coolant inside, wherein the heat exchange unit is coupled to the counterflow heat exchanger via the second coolant piping; and
transport piping having third coolant piping passing a coolant inside, and a third vacuum container forming a vacuum tank between the third vacuum container and the third coolant piping, in which
the coolant piping fixed to the heat shield provided in the cryogenic storage container is coupled to the second coolant piping provided in the cooling source via the third coolant piping, and the vacuum container in the cryogenic storage container is coupled to the second vacuum container in the cooling source via the third vacuum container, wherein:
   in the two provided heat shields provided between the storage container and the vacuum container in the coolant storage container, the heat shield provided on the storage container side is first cooled by the coolant cooled by the cooling source;
   the coolant whose temperature has risen by the cooling is used as a low temperature source of the counterflow heat exchanger in the cooling source to perform heat exchange between the temperature-risen coolant and an opposite coolant in the counterflow heat exchanger;
   the coolant whose temperature has risen by the heat exchange is used in cooling the one provided heat shield between the storage container and the vacuum container; and
   using the coolant whose temperature has risen by the heat exchange with the one provided heat shield provided between the storage container and the vacuum container, the heat shield provided on the vacuum container side in the two provided heat shields between the storage container and the vacuum container is cooled.

Furthermore, the present invention is also an operating method for a cooling system for a cryogenic storage container including:
a cryogenic storage container having a storage container storing a coolant and an object to be cooled, a vacuum container provided around the storage container and forming a vacuum tank between the vacuum container and the storage container, and a heat shield provided in the vacuum tank, wherein the heat shield has a portion having two heat shields between the storage container and the vacuum container, and a portion having one heat shield between the storage container and the vacuum container, coolant piping is fixed to each of the two provided heat shields and the one provided heat shield, a different coolant other than the coolant stored in the storage container passes through the coolant piping, and the coolant passing through the coolant piping cools the two provided heat shield and the one provided heat shield;
a cooling source having a second vacuum container which is vacuum inside, a cryogenic freezer provided in the second vacuum container, at least one heat exchange unit provided in the second vacuum container and attached to a coolness generation unit of the cryogenic freezer, at least one counterflow heat exchanger provided in the second vacuum container, and second coolant piping passing a coolant inside, wherein the heat exchange unit is coupled to the counterflow heat exchanger via the second coolant piping; and
transport piping having third coolant piping passing a coolant inside, and a third vacuum container forming a vacuum tank between the third vacuum container and the third coolant piping, in which
the coolant piping fixed to the heat shield provided in the cryogenic storage container is coupled to the second coolant piping provided in the cooling source via the third coolant piping, and the vacuum container in the cryogenic storage container is coupled to the second vacuum container in the cooling source via the third vacuum container, wherein:
   in the two provided heat shields provided between the storage container and the vacuum container in the coolant storage container, the heat shield provided on the storage container side is first cooled by the coolant cooled by the cooling source;
   the coolant whose temperature has risen by the cooling cools the one provided heat shield between the storage container and the vacuum container;
   the coolant whose temperature has risen by the cooling is used as a low temperature source of the counterflow heat exchanger in the cooling source to perform heat exchange between the temperature-risen coolant and an opposite coolant in the counterflow heat exchanger;
   the coolant whose temperature has risen by the heat exchange cools the heat shield provided on the vacuum container side in the two provided heat shields between the storage container and the vacuum container.

In the present invention, it is desired that the heat shield provided between the storage container and the vacuum container of the cryogenic storage container has a divided structure, and the divided heat shields are coupled by a low thermal conductive material.

It is also desired in the present invention, that a bellows unit is provided at least in a part of the third vacuum container in the coolant transport piping for coupling the cryogenic storage container to the cooling source. It is also desired to provide a bellows unit at least in a part of the third coolant piping in the coolant transport piping.

It is further desired to provide a bellows unit at least a part of the third vacuum container configuring the coolant transport piping, and a part of the bellows unit is fixed to the floor at any portion of the bellows unit.

The present invention can solve the problem of the vibration occurring when a cryogenic freezer is used, and can suppress the amount of evaporation of the liquid helium from the coolant storage container on the cryogenic storage container.

Other objects, features and advantages of the invention will become apparent from the following description of the embodiments of the invention taken in conjunction with the accompanying drawings.

In the drawings:
Fig. 1 is a sectional view of the storage unit of the cryogenic coolant storage container using a superconductive magnet for an NMR according to the present invention;
Fig. 2 is a sectional view of the storage unit of the cryogenic coolant storage container for a superconductive device according to the present invention;
Fig. 3 shows the configuration of the cryogenic storage container according to the present invention;
Fig. 4 is a sectional view of the structure of the heat shield coupling unit according to the present invention;
Fig. 5 is a sectional view of the structure of the cooling source according to the present invention;
Fig. 6 shows the cooling path according to an embodiment of the present invention;
Fig. 7 shows the cooling path according to another embodiment of the present invention; and
Fig. 8 is a sectional view of the transport piping according to the present invention.

The embodiments of the present invention are described below in detail with reference to the attached drawings, but the present invention is not limited to these embodiments.

### [Embodiment 1]

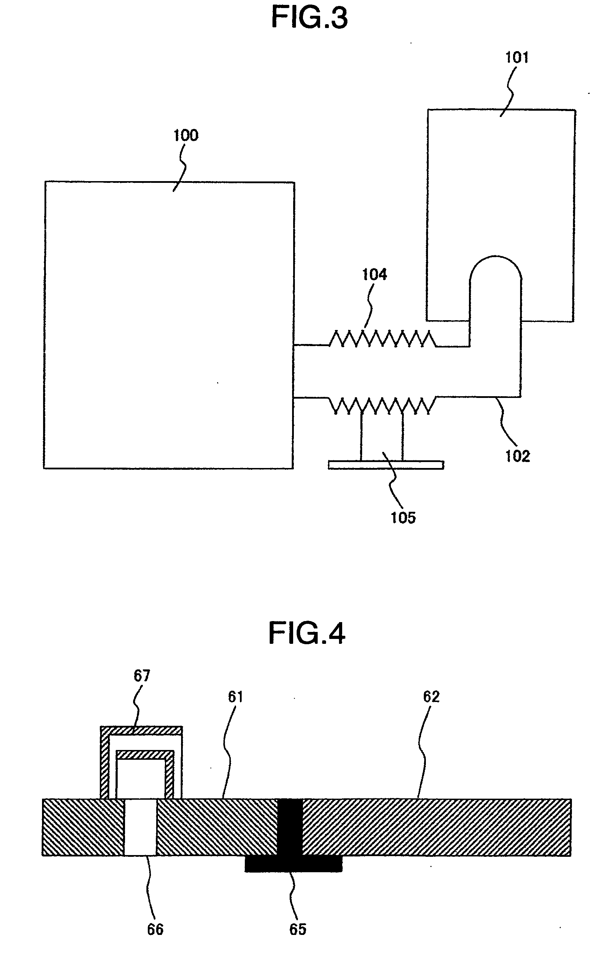

Fig. 3 shows the rough configuration of the cooling system for a cryogenic storage container according to the present invention. The cooling system for a cryogenic storage container according to the present invention is configured by a storage unit 100, a cooling source 101, and a transport piping 102. The cooling source 101 is equipped with a cryogenic freezer not shown in the attached drawings. The cryogenic freezer is coupled to a compressor not shown in the attached drawings via high pressure piping. Using the cryogenic freezer eliminate the necessity to supply a coolant such as liquid nitrogen, liquid helium, etc. In addition, the coolness at or lower than the temperature of liquid nitrogen occurring in the cooling stage of the cryogenic freezer can be used.

In Fig. 3, a bellows unit 104 is provided for a part of the transport piping 102. In the bellows unit 104, the bellows unit 104 is fixed to the floor using a support table 105 at any portion of the bellows unit 104.

The cooling source 101 contains a cryogenic freezer for generating a vibration. The cryogenic freezer provides a constant vibration for the cooling source 101 to which the cryogenic freezer is fixed. The vibration generated by the cooling source 101 is delivered to the storage unit 100 through the transport piping 102.

By providing the bellows unit 104 for at least a part of the transport piping 102, the vibration occurring in the cooling source 101 can be attenuated before reaching the storage unit 100. In addition, in the bellows unit 104 provided for the transport piping 102, the bellows unit 104 can be fixed to the support table 105 on the floor with high rigidity at any portion of the bellows unit, thereby further reducing the vibration on the fixing unit of the bellows unit 104. Furthermore, by the bellows unit 104 between the fixed position of the bellows unit 104 on the floor and the storage unit 100, the vibration to be delivered to the storage unit 100 can be furthermore reduced. The fixing unit between the bellows unit 104 and the support table 105 can be a high rigidity stainless steel pipe etc. However, in this case, it is desired to provide the bellows unit at either ends of the fixing unit.

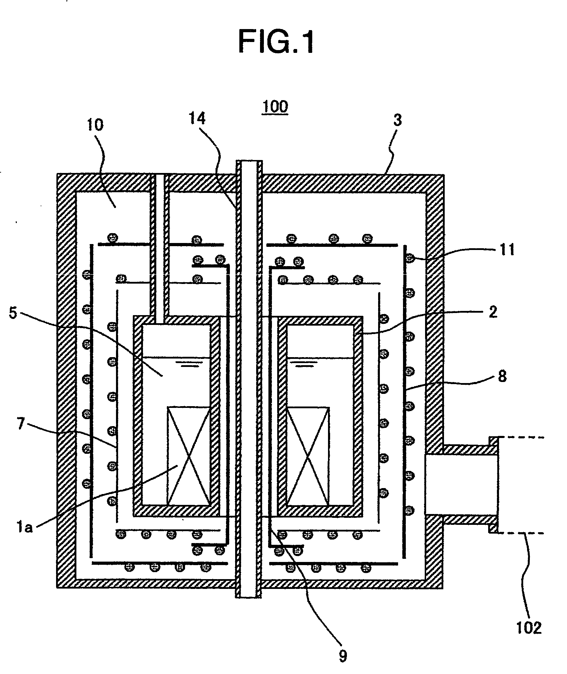

Fig. 1 is a sectional view of the storage unit of the cryogenic coolant storage container using a superconductive magnet for an NMR according to the present invention. The storage unit 100 is configured by a storage container 2 storing a coolant 5 and a superconductive magnet 1a as an object to be cooled, a vacuum container 3 for generating a vacuum tank 10 between the vacuum container 3 and the storage container 2, double heat shields 7 and 8 provided around the storage container 2 in the vacuum tank 10, one provided heat shield 9 between the storage container 2 and the vacuum container 3 in the vacuum tank 10, and a coolant piping 11 passing a coolant for cooling each heat shield.

To effectively utilize a high magnetic field occurring in the superconductive magnet 1a, it is necessary to shorten the distance between the superconductive magnet 1a and the wall of an access port 14 passing through the center of the magnet.

The storage unit 100 is commonly manufactured using stainless steel and aluminum. Especially since the access port 14 has the problem of the magnetic properties of the material, it is desired to use aluminum having low magnetic susceptibility.

In the double heat shields 7 and 8 provided around the storage container 2 in the vacuum tank 10, the heat shield 8 provided on the vacuum container 3 side at the room temperature is referred to as a high temperature shield, and the heat shield 7 provided on the storage container 2 side is referred to as a low temperature shield.

The high temperature shield 8 receives radiation from the vacuum container 3 at the room temperature, and the low temperature shield 7 receives radiation from the high temperature shield 8. At the portion where the double heat shields are provided, the storage container 2 receives radiation from the low temperature shield 7.

On the other hand, the one provided heat shield 9 between the storage container 2 and the vacuum container 3 in the vacuum tank 10 receives radiation from the access port 14 at the room temperature. At the portion where only one heat shield is provided, the storage container 2 receives radiation from the heat shield 9 because there is the storage container 2 inside the heat shield 9.

The heat shields 7, 8, and 9 thermally contact the coolant piping 11 through, for example, an aluminum tape, and are cooled by heat exchange with a coolant cooled at a cryogenic temperature passing in the coolant piping 11. The coolant piping 11 is formed by a stainless steel pipe in a transportation region. The heat contact portion between the heat shields 7, 8, and 9 and the coolant piping 11 is connected by a copper pipe having high thermal conductivity and intensity. When the contact area between the heat shields 7, 8, and 9 and the coolant piping 11 can be sufficiently reserved, the piping of the heat contact portion can be stainless steel. However, it is necessary to decrease the thickness of the piping.

The heat shield 7 provided as a double structure between the storage container 2 and the vacuum container 3 in the vacuum tank 10 is divided, and each of the divided shields is provided with a heat contact portion with the coolant piping 11. The division of the heat shield 7 depends on the shield temperature of the divided heat shield 7, and the shields to be cooled at the same temperature can be coupled. Since the heat shield coupled to the coupling portion (aperture) to the room temperature unit receives thermal conduction from the room temperature, the temperature rises. To reduce the high temperature portion of the heat shield, the heat shield coupled to the coupling portion to the room temperature unit is separated from another heat shield.

Fig. 4 shows the structure for fixing the heat shield division part. When the heat shield is divided, and when there is space between the heat shields, radiant heat occurs and passes through the space. Therefore, a spacer 65 is interposed between heat shields 61 and 62 to be cooled at different temperatures. By using a glass fiber reinforced plastic (GFRP) having low thermal conductivity as the material of the spacer 65, a temperature difference can be made between the heat shields 61 and 62. At this time, when the complete tight state is entered, the heat shield cannot be vacuum inside. Therefore, it is necessary to provide several exhaust holes 66. In addition, to prevent the radiant heat passing through the exhaust holes 66, it is effective to enhance the radiation rate on the inner surfaces of the holes, or cover the surroundings of the exhaust holes with an exhaust shield 67.

Thus, by connecting the heat shields 61 and 62 by a material of low thermal conductivity such as the GFRP etc., a temperature difference between the heat shields can be provided.

The double heat shields 8 provided between the storage container 2 and the vacuum container 3 in the vacuum tank 10 have similar structures as the heat shield 7.

Since it is difficult to provide the coolant piping 11 for the portion having thinner vacuum tank 10, piping is provided for cooling between the double heat shields 7 and 8 between the storage container 2 and the vacuum container 3 in the vacuum tank 10 with respect to the one provided heat shield 9 between the storage container 2 and the access port 14 in the vacuum tank 10.

It is desired that a laminated heat insuring material not shown in the attached drawings is provided between the vacuum container 3 and the high temperature shield 8 in the double heat shields provided between the storage container 2 and the vacuum container 3 in the vacuum tank 10 so that the radiant heat from the vacuum container 3 at the room temperature to the high temperature shield 8 can be reduced.

Similarly, it is also desired to provide a laminated heat insuring material not shown in the attached drawings between the access port 14 and the one provided heat shield 9 between the storage container 2 and the access port 14 in the vacuum tank 10 so that the radiant heat from the vacuum container 3 at the room temperature to the heat shield 9 can be reduced.

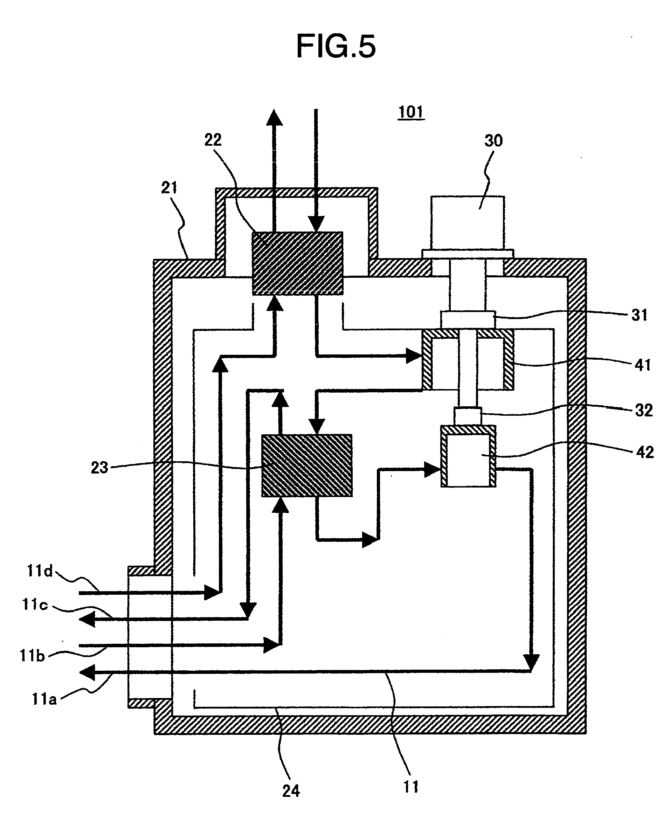

Fig. 5 is a sectional view of the structure of the cooling source according to the present invention. The cooling source 101 is configured by a second vacuum container 21, a cryogenic freezer 30 fixed to the second vacuum container 21, counterflow heat exchangers 22 and 23 provided in the second vacuum container 21, a heat exchange unit 41 thermally coupled to the first cooling stage 31 of the cryogenic freezer 30, a heat exchange unit 42 thermally coupled to a second cooling stage 32 of the cryogenic freezer 30, a heat shield 24 thermally coupled to the first cooling stage 31 of the cryogenic freezer 30, and the coolant piping 11.

In Fig. 5, a Gifford-McMahon freezer (hereinafter referred to as a GM freezer) is used as the cryogenic freezer 30. Although there is only one GM freezer used in the present embodiment, there can be a plurality of freezers depending on the cooling capacity. If there is no problem with the cooling capacity, a pulse pipe freezer generating a lower vibration than the GM freezer can be applied.

A helium gas compressed by a compressor not shown in the attached drawings is charged inside the coolant piping 11. The coolant piping is made of stainless steel. The helium gas supplied to the cooling source 101 from the compressor at the room temperature is processed in heat exchange process with the opposite helium gas when the helium gas passes through the counterflow heat exchanger 22, and is cooled down to a low temperature. Next, the gas is cooled down to the same temperature as the first cooling stage 31 of the cryogenic freezer 30 by the heat exchange unit 41 thermally coupled to the first cooling stage 31 of the cryogenic freezer 30. Next, when it passes through the counterflow heat exchanger 23, it is processed in the heat exchange process with the opposite helium gas, there by further reducing the temperature. Then, the heat exchange unit 42 thermally coupled to the second cooling stage 32 of the cryogenic freezer 30 cools down the gas to the same temperature as the second cooling stage 32 of the cryogenic freezer 30, and the gas is delivered to the storage unit 100 through coolant piping 11a provided in the transport piping 102.

After the temperature of the helium gas has risen by the heat exchange with the heat shield as an object to be cooled in the storage unit 100, the helium gas is fed back to the cooling source 101 through coolant piping 11b, and is used as a low temperature source of the counterflow heat exchanger 23. The heat exchange is performed between the gas and the opposite helium gas. The helium gas whose temperature has risen is delivered to the storage unit 100 through coolant piping 11c. The helium gas whose temperature has risen by the heat exchange with the heat shield as an object to be cooled in the storage unit 100 is fed back to the cooling source 101 through coolant piping 11d, and is used as a low temperature source of the counterflow heat exchanger 22. Then, the heat exchange is performed with the opposite helium gas, and the helium gas whose temperature has risen to the room temperature is returned to the compressor not shown in the attached drawings.

Thus, by adopting the closed circulation system in which no coolant is to be externally supplied, the internal temperature fluctuation is reduced, and a long time continuous operation can be performed.

The heat shield 24 thermally coupled to the first cooling stage 31 of the cryogenic freezer 30 reduces the radiation to the second cooling stage 32 of the cryogenic freezer 30 and the counterflow heat exchanger 23. Between the vacuum container 21 and the heat shield 24 thermally coupled to the first cooling stage 31 of the cryogenic freezer 30, a laminated heat insulating material not shown in the attached drawings is provided to reduce the radiant heat from the vacuum container 21 to the heat shield 24.

The vibration occurring from the cryogenic freezer 30 is reduced by the attenuating mechanism not shown in the attached drawings provided for the second vacuum container 21. The vibration passing through the coolant piping 11 is decreased in the bellows unit not shown in the attached drawings provided at a part of the coolant piping 11. A part of the vacuum container of the transport piping 102 has a bellows structure not shown in the attached drawings, and reduces the vibration passing through the vacuum container. By fixing at the bellows unit of the transport piping 102 to the floor with high rigidity, the vibration in the cooling source 101 can be further prevented from being delivered to the storage unit 100.

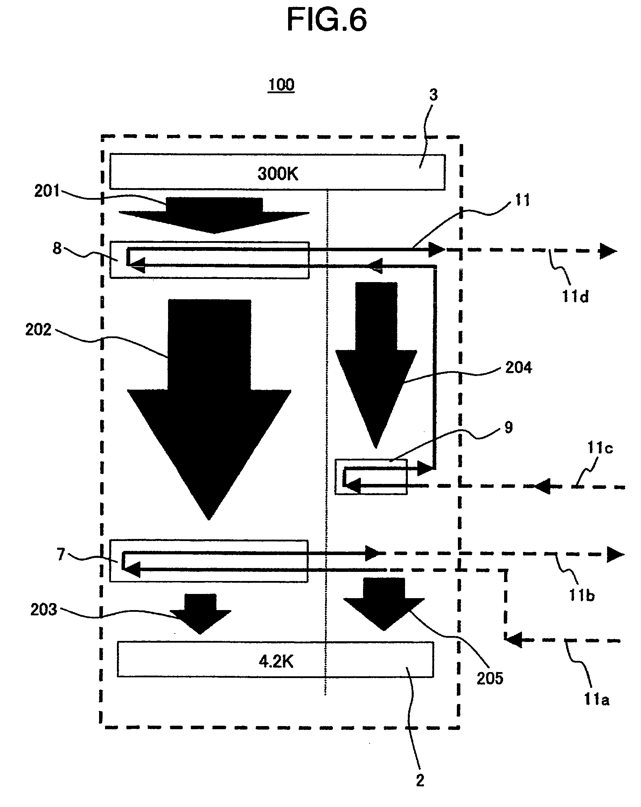

Fig. 6 shows a cooling path of the heat shield provided in the storage unit 100 using a coolant cooled at a cryogenic temperature by the cooling source 101.

In the heat exchange unit 42 thermally coupled to the second cooling stage 32 of the cryogenic freezer 30 in the cooling source 101, the helium gas cooled down to the same temperature as the second cooling stage 32 of the cryogenic freezer 30 is delivered to the storage unit 100 through the coolant piping 11a, and the low temperature shield 7 in the double heat shields between the storage container 2 and the vacuum container 3 in the vacuum tank 10 is cooled. Since there is the high temperature shield 8 around the low temperature shield 7, radiant heat 202 received by the low temperature shield 7 from the high temperature shield 8 is low, and the rise of the temperature of the helium gas passing through the coolant piping 11 is low.

The helium gas whose temperature has risen by the heat exchange with the low temperature shield 7 is temporarily delivered to the cooling source 101 through the coolant piping lib, and is used as a low temperature source of the counterflow heat exchanger 23. The heat exchange is performed between the gas and the opposite helium gas, and the helium gas whose temperature has risen is delivered again to the storage unit 100 through the coolant piping 11c, and the one provided heat shield 9 between the storage container 2 and the vacuum container 3 in the vacuum tank 10 is cooled.

Since the heat shield 9 receives radiant heat 204 from the vacuum container 3 at the room temperature, the temperature of the helium gas as a coolant rises. Using the helium gas whose temperature has risen, the high temperature shield 8 in the two provided heat shields between the storage container 2 and the vacuum container 3 in the vacuum tank 10 is cooled. Since the high temperature shield 8 receives radiant heat 201 from the vacuum container 3 at the room temperature, the temperature of the coolant is furthermore risen.

The helium gas whose temperature has risen by the heat exchange with the heat shield 9 is delivered to the cooling source 101 through the coolant piping 11d, and is used as the low temperature source of the counterflow heat exchanger 22.

As described above, the low temperature shield 7 in the double provided heat shields between the storage container 2 and the vacuum container 3 in the vacuum tank 10 is cooled down to about 4.2 K to 10 K, and the high temperature shield 8 is cooled down to about 70 K to 100 K, and the one provided heat shield 9 between the storage container 2 and the vacuum container 3 in the vacuum tank 10 is cooled down to about 25 K to 45 K. Although the storage container 2 receives radiant heat 203 from the heat shield 7, and radiant heat 205 from the heat shield 9, the amount of evaporation of the liquid helium from the storage container 2 can be suppressed because each heat shield temperature is low.

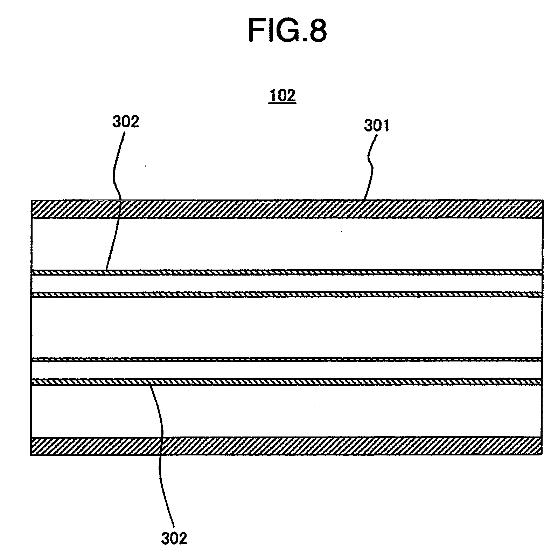

Fig. 8 is a sectional view showing the structure of the transport piping 102. The transport piping 102 is configured by a third vacuum container 301 and coolant piping 302 passing a coolant inside. The bellows unit is used at least a part of the third vacuum container 301 configuring the transport piping 102.

The vacuum container 3, the second vacuum container 21, and a third vacuum container 301 are coupled to one another. Each coolant piping provided in the vacuum container 3, the second vacuum container 21, and the third vacuum container 301 is coupled to realize the cooling path shown in Fig. 6.

### [Embodiment 2]

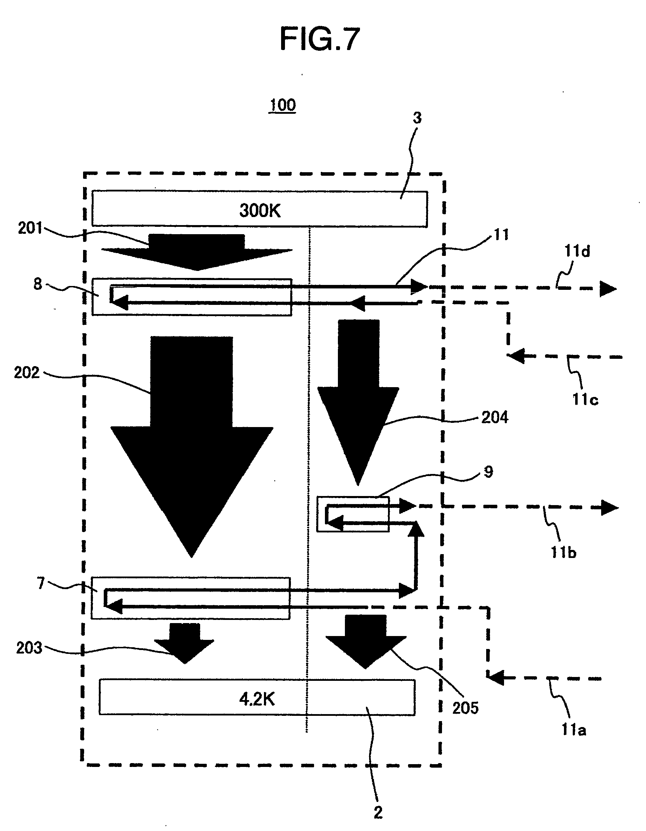

Fig. 7 shows another example of a path for cooling a heat shield provided in the storage unit 100 using a coolant cooled at a cryogenic temperature by the cooling source 101. The entire configuration is the same as shown in Fig. 3. The structure of the storage unit 100 is also the same as the structure shown in Fig. 1. The structure of the cooling source 101 is the same as the structure shown in Fig. 5. The structure of the transport piping 102 is the same as the structure shown in Fig. 8.

The helium gas cooled down to the same temperature as the second cooling stage 32 of the cryogenic freezer 30 by the heat exchange unit 42 thermally coupled to the second cooling stage 32 of the cryogenic freezer 30 in the cooling source 101 is delivered to the storage unit 100 through the coolant piping 11a, and cools the heat shield 7 in the two provided heat shields between the storage container 2 and the vacuum container 3 in the vacuum tank 10. Since there is the high temperature shield 8 around the low temperature shield 7, the radiant heat 202 received by the low temperature shield 7 from the high temperature shield 8 is low, and the rise of the temperature of the helium gas passing the coolant piping 11a is low.

The helium gas whose temperature has risen by the heat exchange with the low temperature shield 7 cools the one provided heat shield 9 between the storage container 2 and the access port 14 in the vacuum tank 10. Since the heat shield 9 receives the radiant heat 204 from the access port 14 at the room temperature, the temperature of the helium gas as a coolant rises. The helium gas whose temperature has risen is temporarily delivered to the cooling source 101 through the coolant piping 11b, and is used as a low temperature source of the counterflow heat exchanger 23.

The helium gas whose temperature has risen by the heat exchange with the opposite helium gas is delivered again to the storage unit 100 through the coolant piping 11c, and cools the high temperature shield 8 in the two provided heat shields between the storage container 2 and the vacuum container 3 in the vacuum tank 10. Since the high temperature shield 8 receives the radiant heat 201 from the vacuum container 3 at a room temperature, it has a large amount of received heat, and the temperature of the coolant further rises.

The helium gas whose temperature has risen by the heat exchange with the high temperature shield 8 is delivered again to the cooling source 101 through the coolant piping 11d, and is used as a low temperature source of the counterflow heat exchanger 22.

As described above, the low temperature shield 7 in the double provided heat shields between the storage container 2 and the vacuum container 3 in the vacuum tank 10 is cooled down to about 10 K to 15 K, and the high temperature shield 8 is cooled down to about 70 K to 100 K, and the one provided heat shield 9 between the storage container 2 and the vacuum container 3 in the vacuum tank 10 is cooled down to about 20 K to 30 K.

According to the present embodiment, the amount of radiant heat to the storage container 2 can be reduced. Although the storage container 2 receives radiant heat 203 from the low temperature shield 7, and radiant heat 205 from the heat shield 9, the amount of evaporation of the liquid helium from the storage container 2 can be suppressed because each heat shield temperature is low.

The cooling system and its operating method of the present invention are not limited to an application to a magnet for an NMR. For example, it is also applicable to a magnet for an MRI.

### [Embodiment 3]

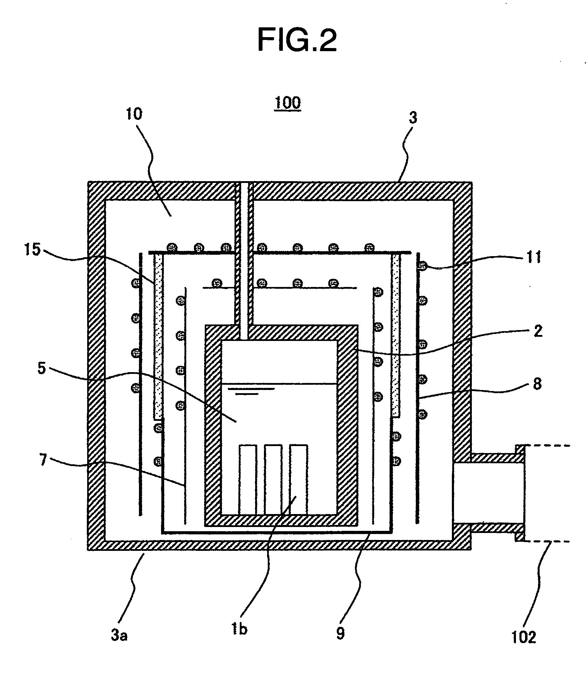

Fig. 2 is a sectional view of the storage unit of the cryogenic storage container storing a superconductive device. The entire configuration of the cryogenic storage container is the same as the configuration shown in Fig. 3. The structure of the cooling source is the same as the structure shown in Fig. 5. The path for circulating a coolant can be any of the circulation paths shown in Figs. 5 and 6. The structure of the transport piping is the same as the structure shown in Fig. 8.

In the present invention, the superconductive device refers to, for example, a superconducting quantum interference device (SQUID) for measuring a weak magnetic field. The SQUID is a high sensitive magnetic sensor capable of measuring a weak magnetic field of 1/1,000,000 or less of the earth's magnetic field. To realize a high sensitive measurement, it is necessary to reduce the thermal noise occurring from the SQUID itself. Therefore, liquid helium is used for cooling at a cryogenic temperature.

The distance from a superconductive device 1b to a measurement surface 3a of the vacuum container 3 largely depends on the measurement sensitivity, and the sensitivity is greatly improved by shortening the distance.

The storage unit 100 stores the coolant 5, and is configured by a storage container 2 storing the superconductive device 1b, the vacuum container 3 for generating the vacuum tank 10 between the vacuum container 3 and the storage container 2, the double heat shields 7 and 8 provided around the storage container 2 in the vacuum tank 10, the one provided heat shield 9 between the storage container 2 and the vacuum container 3 in the vacuum tank 10, and the coolant piping 11 passing a coolant for cooling each heat shield. The vacuum container 3 is connected to the vacuum container of the transport piping 102.

The storage unit 100 is generally manufactured by a non-metal material and a non-magnetic material, and can be manufactured using, for example, a GFRP. Since an eddy-current occurring in the heat shield configuring a storage unit can affect the measurement of the superconductive device 1b, there is no coolant piping 11 around the superconductive device 1b. The joint portion between the heat shield 9 and the coolant piping 11 is provided with a sufficient distance kept to measure the superconductive device. It is common to all heat shields.

The heat shield 9 is supported by a heat insuring support unit 15 made of a material having thermal conductivity lower than that of the heat shields 8 and 9, for example, a GFRP between the heat shield 9 and the heat shield 8. By supporting the high temperature shield 8 and the heat shield 9 by the heat insuring support unit 15, a temperature difference can be made between the high temperature shield 8 and the heat shield 9, thereby successfully maintaining the heat shield 9 at a low temperature.

It should be further understood by those skilled in the art that although the foregoing description has been made on embodiments of the invention, the invention is not limited thereto and various changes and modifications may be made without departing from the spirit of the invention and the scope of the appended claims, as interpreted by the description and drawings.

## Claims

1. A cooling system for a cryogenic storage container including a cryogenic storage container having a storage container (2) storing an object to be cooled as soaked in a coolant (5), a vacuum container (3) provided around the storage container and forming a vacuum tank (10) between the vacuum container and the storage container, and a heat shield (7, 8, 9) provided in the vacuum tank, wherein coolant piping is fixed to the heat shield, and a coolant passing through the coolant piping is cooled by a cryogenic freezer (30), comprising:
a cooling source (101) equipped with the cryogenic storage container; and coolant transport piping (102) for coupling the cooling source to the cryogenic storage container, wherein the coolant cooled by the cryogenic freezer is delivered to the cryogenic storage container through the transport piping.

2. The cooling system for a cryogenic storage container according to claim 1, wherein
a bellows unit is provided for at least a part of the coolant transport piping.

3. The cooling system for a cryogenic storage container according to claim 1, wherein
the coolant transport piping is configured by coolant piping for passing a coolant inside, and a vacuum container surrounding the piping, and a bellows unit is provided for at least a part of the vacuum container.

4. The cooling system for a cryogenic storage container according to claim 3, wherein
the system is fixed to a floor at any portion of the bellows unit provided for the vacuum container in the coolant transport piping.

5. The cooling system for a cryogenic storage container according to claim 3, wherein
a bellows unit is provided for at least a part of the coolant piping in the coolant transport piping.

6. The cooling system for a cryogenic storage container according to claim 1, wherein:
the cryogenic storage container has a portion provided with two heat shields (7, 8) and a portion provided with one heat shield (9) between the storage container and the vacuum container;
the cooling source is provided with a second vacuum container (21) which is vacuum inside, the cryogenic freezer attached to the second vacuum container, at least one heat exchange unit provided in the second vacuum container and attached to a coolness generation unit of the cryogenic freezer, at least one counterflow heat exchanger provided in the second vacuum container, and second coolant piping passing a coolant inside;
the heat exchange unit and the counterflow heat exchanger are coupled by the second coolant piping;
the coolant transport piping has third coolant piping passing a coolant inside, and a third vacuum container (301) forming a vacuum tank between the third coolant piping and the third vacuum container; and
coolant piping fixed to the heat shield, the second coolant piping provided for the cooling source, and the third coolant piping in the coolant transport piping are coupled.

7. The cooling system for a cryogenic storage container according to claim 6, wherein
a vacuum container configuring the cryogenic storage container is coupled to the second vacuum container configuring the cooling source by the third vacuum container configuring the coolant transport piping.

8. The cooling system for a cryogenic storage container according to claim 1, wherein
the heat shield provided between the storage container and the vacuum container has a divided structure, and the divided heat shields are coupled by a material having lower thermal conductivity than the heat shield.

9. An operating method for the cooling system for a cryogenic storage container according to claim 6, wherein:
in the two provided heat shields between the storage container and the vacuum container configuring the cryogenic storage container, a heat shield provided on the storage container side is first cooled by a coolant cooled by the cooling source;
the coolant whose temperature has risen by the cooling is used as a low temperature source of the counterflow heat exchanger in the cooling source to perform heat exchange between the temperature-risen coolant and an opposite coolant in the counterflow heat exchanger;
the coolant whose temperature has risen by the heat exchange cools the one provided heat shield between the storage container and the vacuum container; and
the coolant whose temperature has risen by the heat exchange with the one provided heat shield between the storage container and the vacuum container cools a heat shield provided on the vacuum container side in the two provided heat shields between the storage container and the vacuum container.

10. An operating method for the cooling system for a cryogenic storage container according to claim 6, wherein:
in the two provided heat shields between the storage container and the vacuum container configuring the cryogenic storage container, a heat shield provided on the storage container side is first cooled by a coolant cooled by the cooling source;
the coolant whose temperature has risen by the cooling cools the one provided heat shield between the storage container and the vacuum container;
the coolant whose temperature has risen by the heat exchange with the one provided heat shield between the storage container and the vacuum container is used as a low temperature source of the counterflow heat exchanger in the cooling source and heat exchange is performed between the temperature-risen coolant and an opposite coolant in the counterflow heat exchanger; and
the coolant whose temperature has risen by the heat exchange cools a heat shield provided on the vacuum container side in the two provided heat shields between the storage container and the vacuum container.

11. A cooling system for a cryogenic storage container, comprising:
a cryogenic storage container having a storage container storing a coolant (5) and an object to be cooled, a vacuum container (3) provided around the storage container and forming a vacuum tank (10) between the vacuum container and the storage container, and a heat shield provided in the vacuum tank, wherein the heat shield has a portion having two heat shields (7, 8) between the storage container and the vacuum container, and a portion having one heat shield (9) between the storage container and the vacuum container, coolant piping is fixed to each of the two provided heat shields and the one provided heat shield, a different coolant other than the coolant stored in the storage container passes through the coolant piping, and the coolant passing through the coolant piping cools the two provided heat shield and the one provided heat shield;
a cooling source (101) having a second vacuum container (21) which is vacuum inside, a cryogenic freezer (30) provided in the second vacuum container, at least one heat exchange unit provided in the second vacuum container and attached to a coolness generation unit of the cryogenic freezer, at least one counterflow heat exchanger provided in the second vacuum container, and second coolant piping passing a coolant inside, wherein the heat exchange unit is coupled to the counterflow heat exchanger via the second coolant piping; and
transport piping having third coolant piping passing a coolant inside, and a third vacuum container (301) forming a vacuum tank (10) between the third vacuum container and the third coolant piping, wherein
the coolant piping fixed to the heat shield provided in the cryogenic storage container is coupled to the second coolant piping provided in the cooling source via the third coolant piping, and the vacuum container in the cryogenic storage container is coupled to the second vacuum container in the cooling source via the third vacuum container.

12. An operating method for a cooling system for a cryogenic storage container, comprising:
a cryogenic storage container having a storage container storing a coolant (5) and an object to be cooled, a vacuum container (3) provided around the storage container and forming a vacuum tank (10) between the vacuum container and the storage container, and a heat shield provided in the vacuum tank, wherein the heat shield has a portion having two heat shields (7, 8) between the storage container and the vacuum container, and a portion having one heat shield (9) between the storage container and the vacuum container, coolant piping is fixed to each of the two provided heat shields and the one provided heat shield, a different coolant other than the coolant stored in the storage container passes through the coolant piping, and the coolant passing through the coolant piping cools the two provided heat shield and the one provided heat shield;
a cooling source (101) having a second vacuum container (21) which is vacuum inside, a cryogenic freezer (30) provided in the second vacuum container, at least one heat exchange unit provided in the second vacuum container and attached to a coolness generation unit of the cryogenic freezer, at least one counterflow heat exchanger provided in the second vacuum container, and second coolant piping passing a coolant inside, wherein the heat exchange unit is coupled to the counterflow heat exchanger via the second coolant piping; and
transport piping (102) having third coolant piping (302) passing a coolant inside, and a third vacuum container (301) forming a vacuum tank between the third vacuum container and the third coolant piping, in which
the coolant piping fixed to the heat shield provided in the cryogenic storage container is coupled to the second coolant piping provided in the cooling source via the third coolant piping, and the vacuum container in the cryogenic storage container is coupled to the second vacuum container in the cooling source via the third vacuum container, wherein:
in the two provided heat shields provided between the storage container and the vacuum container in the coolant storage container, the heat shield provided on the storage container side is first cooled by the coolant cooled by the cooling source;
the coolant whose temperature has risen by the cooling is used as a low temperature source of the counterflow heat exchanger in the cooling source to perform heat exchange between the temperature-risen coolant and an opposite coolant in the counterflow heat exchanger;
the coolant whose temperature has risen by the heat exchange is used in cooling the one provided heat shield between the storage container and the vacuum container; and
using the coolant whose temperature has risen by the heat exchange with the one provided heat shield provided between the storage container and the vacuum container, the heat shield provided on the vacuum container side in the two provided heat shields between the storage container and the vacuum container is cooled.

13. An operating method for a cooling system for a cryogenic storage container, comprising:
a cryogenic storage container having a storage container (2) storing a coolant (5) and an object to be cooled, a vacuum container (3) provided around the storage container and forming a vacuum tank (10) between the vacuum container and the storage container, and a heat shield provided in the vacuum tank, wherein the heat shield has a portion having two heat shields (7, 8) between the storage container and the vacuum container, and a portion having one heat shield (9) between the storage container and the vacuum container, coolant piping is fixed to each of the two provided heat shields and the one provided heat shield, a different coolant other than the coolant stored in the storage container passes through the coolant piping, and the coolant passing through the coolant piping cools the two provided heat shield and the one provided heat shield;
a cooling source (101) having a second vacuum container (21) which is vacuum inside, a cryogenic freezer (30) provided in the second vacuum container, at least one heat exchange unit provided in the second vacuum container and attached to a coolness generation unit of the cryogenic freezer, at least one counterflow heat exchanger (22, 23) provided in the second vacuum container, and second coolant piping passing a coolant inside, wherein the heat exchange unit is coupled to the counterflow heat exchanger via the second coolant piping; and
transport piping (102) having third coolant piping passing a coolant inside, and a third vacuum container (301) forming a vacuum tank (3) between the third vacuum container and the third coolant piping, in which
the coolant piping fixed to the heat shield provided in the cryogenic storage container is coupled to the second coolant piping provided in the cooling source via the third coolant piping, and the vacuum container in the cryogenic storage container is coupled to the second vacuum container in the cooling source via the third vacuum container, wherein:
in the two provided heat shields provided between the storage container and the vacuum container in the coolant storage container, the heat shield provided on the storage container side is first cooled by the coolant cooled by the cooling source;
the coolant whose temperature has risen by the cooling cools the one provided heat shield between the storage container and the vacuum container;
the coolant whose temperature has risen by the cooling is used as a low temperature source of the counterflow heat exchanger in the cooling source to perform heat exchange between the temperature-risen coolant and an opposite coolant by the counterflow heat exchanger; and
the coolant whose temperature has risen by the heat exchange cools the heat shield provided on the vacuum container side in the two provided heat shields between the storage container and the vacuum container.
